# EUROPEAN PATENT APPLICATION

(11) **EP 4 345 476 A1**
(43) Date of publication of application: **03.04.2024**
(21) Application number: 22198939.5
(22) Date of filing: 30.09.2022
(51) Int. Cl.: G01R 33/3815, H01B 7/06, H01B 12/00, H01F 6/06

(54) **SUPERCONDUCTING WIRE AND MANUFACTURING METHOD THEREFORE**

(71) Applicant: Koninklijke Philips N.V., 5656 AG Eindhoven (NL)
(72) Inventor: FORTHMANN, Peter, Eindhoven (NL)
(74) Representative: Philips Intellectual Property & Standards

(57) **Abstract**

The invention relates to an electrically conducting wire, the wire (4) being formed as a flexible helix with constant or changing slope, with constant or changing diameter and with straight or curved extension, wherein the wire comprises a superconductor. In this way, a wire is provided that comprises a superconductor and that allows small bending radii, especially lower than 15 cm,

## Description

### FIELD OF THE INVENTION

The invention relates to the field of electrically conducting wires with superconductors, and in particular to electrically conducting wires with superconductors for a magnetic resonance imaging cryostat.

### BACKGROUND OF THE INVENTION

Superconducting magnets may be used in systems that require strong magnetic fields, such as magnetic resonance imaging (MRI) and nuclear magnetic resonance (NMR) spectrometry, for example. To realize superconductivity, a magnet includes one or more electrically conductive coils, which are formed from superconducting wire. In order to maintain superconductivity for conventional superconductors, a cryogenic environment (cryostat) at a temperature near absolute zero during operation is necessary. In the superconducting state, the electrically conductive coils are referred to as superconducting coils, which effectively have no electrical resistance, and therefore conduct much larger electric currents to create strong magnetic fields. In this respect, ordinary metallic superconductors are well known, which usually work below 77 K.

There also exist high-temperature superconductors (HTS) which are operatively defined as materials that behave as superconductors at temperatures above 77 K, the boiling point of liquid nitrogen, one of the simplest coolants in cryogenics. All materials currently known to conduct at ordinary pressures become superconducting at temperatures far below ambient, and therefore require cooling. The majority of high-temperature superconductors are ceramic materials. Ceramic superconductors are becoming suitable for some practical use, but they still have many manufacturing issues and there are only few successful practical examples of employment. Most ceramics are brittle, which makes the fabrication of wires from them problematic.

Magnesium diboride (MgB₂) is a promising superconductor with a higher operating temperature than conventional NbTi conductors. MgB₂ becomes superconducting below 39 K; this is far less than the about 150 K of YBaCuO-HTC material, but still has the advantage that cooling capacity is much higher at 39 K than at 9.7 K, which is required for cooling NbTi. This relaxes many of the thermal constraints that drive the cost of a cryostat for magnetic resonance imaging (MRI cryostat). As mentioned above, one of the drawbacks of conventional MgB₂ wires, however, is that they are brittle. Bending radii below the order of 15 cm can lead to cracking and loss of function. This can be a serious limitation when routing the wire.

Manufacturing methods for MgB₂ wires are well known (see for example A. Ballarino and R. Flükiger 2017 J. Phys.: Conf. Ser. 871 012098 or M. N. Kutukcu et al., "Composite Superconducting MgB2 Wires Made by Continuous Process," in IEEE Transactions on Applied Superconductivity, vol. 28, no. 4, pp. 1-4, June 2018, Art no. 6200704). The most important methods for manufacturing MgB₂ wires are ex situ and in situ. Further, a magnesium diffusion technique exists. For example, for the ex-situ method, pre-reacted MgB₂ powders with a molar ratio of 1:2 are inserted into a Nb tube, surrounded by a Cu_{.70}Cu_{.30} tube and drawn to a wire of about 3.5 mm diameter. Several pieces of wires are then inserted in a Nickel or Monel tube, together with OFHC Cu for stabilization. This composite is groove rolled and drawn to a round wire with a diameter of 2 mm, which is twisted before to be rolled to a tape (typically 3.6 x 0.65 mm²) or to a wire of about 1 mm diameter, followed by a recrystallization heat treatment of typically 4 minutes at 965°C. For in situ MgB₂ wires, the initial MgB₂ mixture consists of Mg and B powders. This alternative has the advantage that the reaction to MgB₂ occurs at considerably lower temperatures (around 650 °C), thus reducing the reaction layer at the metallic sheath.

In J. Breitschopf et al 2020 IOP Conf. Ser.: Mater. Sci. Eng. 756 012031, results are reported in the development of 2-layer cable-in-conduit (SuperCIC) that is designed for use in hybrid-coil magnets. SuperCIC preserves the full performance of the individual wires, and can be formed into flared- end windings for dipoles into layer-wound toroids and solenoids for hybrid windings for tokamaks. The structure of the SuperCIC windings is designed to accommodate winding and heat-treating sub-windings of Bi-2212, Nb₃Sn, and NbTi separately and then assembling them and preloading in the magnet.

### SUMMARY OF THE INVENTION

It is an object of the invention to provide electrically conducting wires that comprise a superconductor and that allow small bending radii, especially lower than 15 cm, when routing the wires without cracking and loss of function.

According to the invention, this object is addressed by the subject matter of the independent claims. Preferred embodiments of the invention are described in the dependent claims.

Therefore, according to the invention, an electrically conducting wire is provided, the wire being formed as a flexible helix with constant or changing slope, with constant or changing diameter, with straight or curved extension and with straight or curved extension, wherein the wire comprises a superconductor.

Usually, a helix a is defined as a curve that winds around the mantle of a cylinder which defines a diameter and with a constant slope. However, according to the present invention, also such geometries are understood to be a helix which show a changing slope and/or a changing diameter along their respective extension and/or a straight or curved extension. This means, the extension of the helix does not have to be straight as is the axis of a cylinder. Rather, the invention also allows for a curved extension of the helix which does not follow a straight line.

It is an essential aspect of the invention that bending a helix puts less stress on the individual wire turns and therefore allows smaller bend radii than allowable for a straight wire. Therefore, the electrically conducting wire according to the invention is of great advantage when routing the wire, since the risk of cracking and loss of function of the wire is considerably reduced due to the shape of the electrically conducting wire which is the shape of a flexible helix with constant or changing slope, with constant or changing diameter and with straight or curved extension. Hence, the invention makes use of the fact that the required bending moment is distributed over a longer wire length or the bending moment is converted into torsion which is also distributed over several loops.

In general, different superconductors can be used for the electrically conducting wire. However, according to a preferred embodiment of the invention, the wire comprises MgB₂ as a superconductor. As mentioned above, MgB₂ is a superconductor with a higher operating temperature than conventional NbTi conductors. MgB₂ becomes superconducting below 39 K which is far less than the about 150 K of YBaCuO-HTC material, but still has the advantage that cooling capacity is much higher at 39 K than at 9.7 K, which is required for cooling NbTi. Therefore, many of the thermal constraints that drive the cost of a cryostat for MRI cryostat may be solved in this way. The drawback of conventional MgB₂ wires, i.e. that it is brittle and may, therefore, easily crack, is overcome due the shape of a flexible helix. In this way, bending radii below 15 cm are easily achievable, which is of great advantage when routing the wire.

Different dimensions can be used for the flexible helix. However, according to a preferred embodiment of the invention, the diameter of the helix is between 1.5 cm and 8 cm, preferably between 3.5 cm and 6.5 cm. Further, it is preferred that the electrically conducting wire has a diameter of between 0.4 and 1.6 mm, preferably between 0.8 mm and 1.2 mm. Further, according to a preferred embodiment of the invention, the electrically conducting wire has a length such that the number of windings is between 6 and 12, preferably between 8 and 10, when neighboring windings are in contact with each other. For example, this means that if the diameter of the flexible helix in its relaxed state is 5 cm and the number of windings is 10, the length of the wire is approx. 157 cm.

The electrically conducting wire may have a constant winding direction which means that the windings follow the shape of a circle with a constant slope. However, according to a preferred embodiment of the invention, the winding direction of the flexible helix changes after each full turn. Here, a full turn is defined as a winding within the range of 340 ° to 380 °. In this respect, it is especially preferred that the wire is bent back by 180 ° towards its previous course after each full turn. This may be advantageous for field sensitive applications since winding portions which run antiparallel to each other may compensate each other.

Though a single flexible helix, in general, is sufficient for the invention, according to a preferred embodiment, two electrically conducting wires are provided which are formed as a double helix with alternating winding directions. This may also be advantageous for field sensitive applications since winding portions which run antiparallel to each other may compensate each other.

The invention is also directed to the use of an electrically conducting wire or an electrically conducting wire assembly as described above for electrically connecting the windings of a magnet in a magnetic resonance imaging cryostat, where, preferably, the magnet is a superconducting magnet. As mentioned above, such a use is advantageous since the routing of the wire gets easier since there is a reduced risk of breaking. In this respect, it is preferred that the electrically conducting wire or the electrically conducting wire assembly is guided via a bending that is equal or greater than 90 ° and or that comprises a bending radius of 15 cm or less.

Further, the invention is also directed to an assembly for a magnetic resonance imaging apparatus, comprising a cryostat, a magnet with multiple windings arranged within the cryostat and an electrically conducting wire or an electrically conducting wire assembly as described above, wherein the electrically conducting wire or the electrically conducting wire assembly is electrically connected to windings of the magnet.

Furthermore, the invention is also directed to a manufacturing method for an electrically conducting wire, comprising the following method steps:
arranging material comprising i) pre-reacted MgB₂ powder or ii) Mg powder and B powder in the form of a flexible helix with constant or changing slope and with constant or changing diameter, and
heat treating the arranged material.

In this respect, in case i) the heat treating is preferably performed at a temperature between 930 °C and 1000 °C, preferably at 965 °C, for a time between 2 min and 6 min, preferably for 4 min. Further, it is preferred that in case ii) the heat treating is performed at a temperature between 600 °C and 750 °c, preferably at 650 °C, for a time between 30 min and 50 min, preferably for 40 min.

Finally, the invention is also directed to a manufacturing method for an electrically conducting wire, comprising the following method steps:
a) arranging a pure Mg rod at the center of a Ta or Nb tube,
b) filling the area between the area between the Mg rod and the Ta or Nb tube with B and C,
c) repeating steps a) and b) for additional Mg rods and Ta or Nb tubes,
d) bundling the filled rods,
e) inserting the bundled and filled rods into a Cu-Ni tube,
f) cold deforming the filled Cu-Ni tube in the form of a helix with constant or changing slope, with constant or changing diameter and with straight or curved extension, and
g) heat treating the arranged material.

In this respect, it is preferred that C is provided as a carbon layer on the surface of the B particles or as C₁₄H₁₂ powders. Further, the heat treatment is preferably performed in a temperature range between 630 and 650 °C, preferably at 640 °C. In this way, Mg diffuses into the B particles and reacts to form MgB₂ layers of 10 to 30 µm thickness along the inner wall of the Ta tube.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a cryostat with two electrically conducting wires according to a preferred embodiment of the invention which are each formed as a flexible helix,
Fig. 2 schematically depicts an electrically conducting wire assembly with two electrically conducting wires according to a preferred embodiment of the invention, wherein the two electrically conducting wires are formed as a double helix with alternating winding directions.
Fig. 3 schematically depicts an electrically conducting wire according to a preferred embodiment of the invention, wherein the winding direction of the helix changes after each 360 ° winding,
Fig. 4 depicts the method steps of a manufacturing method for an electrically conducting wire according to a first preferred embodiment of the invention and
Fig. 5 depicts the method steps of a manufacturing method for a electrically conducting wire according to a second preferred embodiment of the invention

### DETAILED DESCRIPTION OF EMBODIMENTS

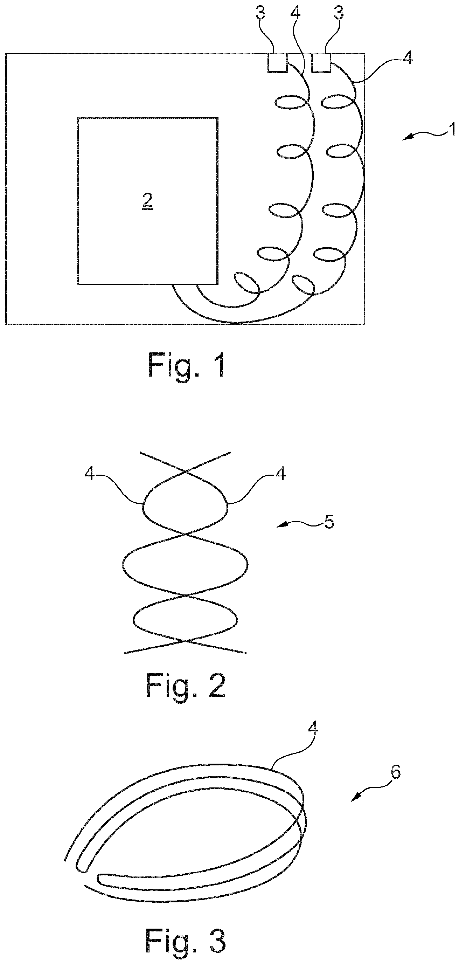

Fig. 1 schematically depicts a MRI cryostat 1 with two electrically conducting wires 4 according to a preferred embodiment of the invention. The electrically conducting wires 4 are both formed as a flexible helix. Here, the term "flexible helix" does not only relate to such conventional helix shapes which are defined as a curve that winds around the mantle of a cylinder which defines a diameter and with a constant slope. Rather, here also such geometries are understood to be a flexible helix which show a changing slope and/or a changing diameter along their respective extension. Further, the extension of the helix does not have to be straight as is the axis of a cylinder. Rather, the invention also allows for a curved extension of the helix which does not follow a straight line.

As depicted in Fig. 1, the electrically conducting wires 4 are routed in the MRI cryostat 1 from two electric terminals 3 to a super conducting magnet 4. Though this routing of the electrically conducting wires 4 means bending the wires 4, there is only a small risk of breakage since the electrically conducting wires 4 are shaped as a flexible helix. Therefore, this preferred embodiment of the invention takes advantage from the fact that bending a helix instead of a straight wire puts less stress on the individual wire turns and therefore allows smaller bend radii than allowable for a straight wire. This means that the electrically conducting wires 4 may even be formed from a brittle material.

According to the preferred embodiment of the invention described here, the electrically conducting wires 4 both comprise MgB₂ as a superconductor. As mentioned above, MgB₂ becomes superconducting below 39 K which has the advantage that cooling capacity is much higher at 39 K than at 9.7 K which is required for cooling NbTi. In this way, the drawback of conventional MgB₂ wires, i.e. that they are brittle and may, therefore, easily crack, is overcome due the shape of a flexible helix.

Here, the electrically conducting wire has a diameter of the helix which is 5 cm and the electrically conducting wire 4 has a diameter which is 1 mm. Further, as can be understood from Fig. 1, the number of windings of each electrically conducting wire 4 is six.

Further, Fig. 2 schematically depicts an assembly with two electrically conducting wires 4 according to another preferred embodiment of the invention. Here, the two electrically conducting wires 4 are formed as a double helix wire assembly 5 with alternating winding directions. Since the currents in such alternating windings may compensate each other such a design is advantageous for field sensitive applications.

Fig. 3 schematically depicts an electrically conducting wire 4 according to another preferred embodiment of the invention which is also advantageous for field sensitive applications. Here, a helix 6 is provided wherein the winding direction of the helix 6 changes after each 360 ° winding.

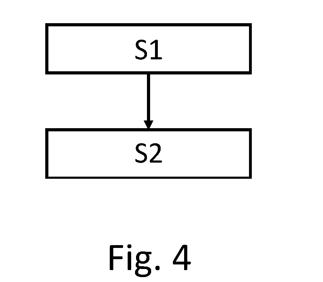

The method steps of a manufacturing method according to a first preferred embodiment of the invention is depicted in Fig. 4. This manufacturing method comprises the following method steps:
S1) arranging material comprising i) pre-reacted MgB₂ powder or ii) Mg powder and B powder in the form of a helix with constant or changing slope, with constant or changing diameter and with straight or curved extension, and
S2) heat treating the arranged material.

This means that this preferred embodiment of the invention allows for two alternatives, i.e. using pre-reacted MgB₂ powder or Mg powder and B powder. In both cases these materials are arranged in the form of a helix with constant or changing slope, with constant or changing diameter and with straight or curved extension. However, the heat treating in step S2 is different for both cases. In case i), the heat treating is performed at a temperature at 965 °C for 4 min. In contrast to that, in case ii) the heat treating is performed at a temperature at 650 °C for 40 min.

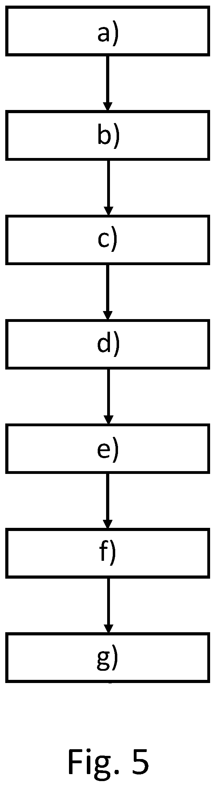

Fig. 5 depicts the method steps of a manufacturing method according to a second preferred embodiment of the invention. This method comprises the following method steps:
a) arranging a pure Mg rod at the center of a Ta or Nb tube,
b) filling the area between the area between the Mg rod and the Ta or Nb tube with B and C,
c) repeating steps a) and b) for additional Mg rods and Ta or Nb tubes,
d) bundling the filled rods,
e) inserting the bundled and filled rods into a Cu-Ni tube,
f) cold deforming the filled Cu-Ni tube in the form of a helix with constant or changing slope, with constant or changing diameter and with straight or curved extension, and
g) heat treating the arranged material.

Here, C is provided as a carbon layer on the surface of the B particles or as C₁₄H₁₂ powders. Further, the heat treatment is performed at 640 °C. In this way, Mg diffuses into the B particles and reacts to form MgB₂ layers of 10 to 30 µm thickness along the inner wall of the Ta tube.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| MRI cryostat | 1 |
| magnet | 2 |
| electrical terminals | 3 |
| superconducting wire | 4 |
| double helix wire assembly | 5 |
| helix with changing winding directions | 6 |

## Claims

1. Electrically conducting wire, the wire (4) being formed as a flexible helix with constant or changing slope, with constant or changing diameter and with straight or curved extension, wherein the wire comprises a superconductor.

2. Electrically conducting wire according to claim 1, wherein the wire (4) comprises MgB₂ as a superconductor.

3. Electrically conducting wire according to claim 1 or 2, wherein the diameter of the helix is between 1.5 cm and 8 cm, preferably between 3.5 cm and 6.5 cm.

4. Electrically conducting wire according to any of the previous claims, wherein the diameter of the wire (4) is between 0.4 and 1.6 mm, preferably between 0.8 mm and 1.2 mm.

5. Electrically conducting wire according to any of the previous claims, wherein the wire (4) has a length such that the number of windings is between 6 and 12, preferably between 8 and 10, when neighboring windings are in contact with each other.

6. Electrically conducting wire according to any of the previous claims, wherein the helix is a helix (6) with changing directions wherein winding direction of the helix (6) changes after each full turn.

7. Electrically conducting wire according to claim 6, wherein the wire (4) is bent back by 180 ° towards its previous course after a full turn.

8. Electrically conducting wire assembly with two electrically conducting wires (4) according to any of claims 1 to 6, wherein the two electrically conducting wires are formed as a double helix (5) with alternating winding directions.

9. Use of an electrically conducting wire according to any of claims 1 to 7 or an electrically conducting wire assembly according to claim 8 for electrically connecting the windings of a magnet (2) in a magnetic resonance imaging cryostat (1).

10. Use according to claim 9, wherein the electrically conducting wire or the electrically conducting wire assembly is guided via a bending that is equal or greater than 90 ° and/or that comprises a bending radius of 15 cm or less.

11. Assembly for a magnetic resonance imaging apparatus, comprising
a cryostat (1), a magnet (2) with multiple windings arranged within the cryostat (1) and an electrically conducting wire according to any of claims 1 to 7 or an electrically conducting wire assembly according to claim 8, wherein the electrically conducting wire or the electrically conducting wire assembly is electrically connected to windings of the magnet (2).

12. Manufacturing method for an electrically conducting wire, comprising the following method steps:
S1) arranging material comprising i) pre-reacted MgB₂ powder or ii) Mg powder and B powder in the form of a helix with constant or changing slope, with constant or changing diameter, and with straight or curved extension, and
S2) heat treating the arranged material.

13. Manufacturing method according to claim 12, wherein the heat treating is performed at a temperature between 930 °C and 1000 °C, preferably at 965 °C, for a time between 2 min and 6 min, preferably for 4 min.

14. Manufacturing method according to claim 12, wherein in case ii) the heat treating is performed at a temperature between 600 °C and 750 °c, preferably at 650 °C, for a time between 30 min and 50 min, preferably for 40 min.

15. Manufacturing method for an electrically conducting wire, comprising the following method steps:
a) arranging a pure Mg rod at the center of a Ta or Nb tube,
b) filling the area between the area between the Mg rod and the Ta or Nb tube with B and C,
c) repeating steps a) and b) for additional Mg rods and Ta or Nb tubes,
d) bundling the filled rods,
e) inserting the bundled and filled rods into a Cu-Ni tube,
f) cold deforming the filled Cu-Ni tube in the form of a helix with constant or changing slope, with constant or changing diameter and with straight or curved extension, and
g) heat treating the arranged material.
